# EUROPÄISCHE PATENTSCHRIFT

(11) **EP 1 510 115 B1**
(45) Veröffentlichungstag und Bekanntmachung des Hinweises auf die Patenterteilung: **23.11.2005**
(21) Anmeldenummer: 03756961.3
(22) Anmeldetag: 02.06.2003
(51) Int. Cl.: H05K 13/02

(54) **BAUELEMENTEGURT-TRANSPORTRAD, BAUELEMENTEGURT-TRANSPORTSYSTEM UND VERFAHREN ZUM BETREIBEN EINES BAUELEMENTEGURT-TRANSPORTSYSTEMS**
COMPONENT BELT CONVEYOR WHEEL, COMPONENT BELT CONVEYOR SYSTEM AND METHOD FOR OPERATING A COMPONENT BELT CONVEYOR SYSTEM
ROUE TRANSPORTEUSE A COURROIE A ELEMENTS, SYSTEME TRANSPORTEUR A COURROIE A ELEMENTS ET PROCEDE D'EXPLOITATION D'UN SYSTEME TRANSPORTEUR A COURROIE A ELEMENTS

(30) Priorität: 05.06.2002 DE 10224998
(43) Veröffentlichungstag der Anmeldung: 02.03.2005
(73) Patentinhaber: SIEMENS AKTIENGESELLSCHAFT, 80333 München (DE)
(72) Erfinder: LIEBEKE, Thomas, 85521 Ottobrunn (DE); WALLNER, Herbert, 71101 Schönaich (DE)
(86) Internationale Anmeldenummer: PCT/DE2003/001821
(87) Internationale Veröffentlichungsnummer: WO 2003/105556

(56) Entgegenhaltungen:
- EP-A1- 0 589 275
- WO-A1-03/101172
- DE-A1- 3 736 530
- US-A- 6 032 845

## Beschreibung

Die Erfindung betrifft ein Bauelementegurt-Transportrad, ein Bauelementegurt-Transportsystem sowie ein Verfahren zum Betreiben eines Bauelementgurt-Transportsystems, bei welchem das Bauelementegurt-Transportrad einen scheibenförmigen Innenkörper aufweist, von welchem sich eine Mehrzahl von Transportstiften jeweils radial erstrecken, die beim Transport von Bauelementgurten in deren Transportöffnungen eingreifen können.

Bauelementgurte stellen heute die wichtigste Verpackungsform von Bauelementen dar. Die Gurte der Bauelemente sind sowohl für eine Fertigung mit hohen Stückzahlen als auch für kleine Losgrößen geeignet, die häufiges Umrüsten erforderlich machen. Die Bauelementgurte werden mittels Zuführmodulen einer Bestückvorrichtung zum Bestücken von beispielsweise SMD-Bauelementen bereitgestellt. Dabei haben die Zuführmodule die Aufgabe, für eine störungsfreie Bereitstellung der Bauelemente aus dem Gurt zu sorgen. Der Bauelementgurt läuft dabei von einer Rolle in das Zuführmodul, wobei das Abdeckband von dem Gurt abzogen wird, so dass die Bauelemente an einer Abholposition von einem Bestückkopf beispielsweise nach oben entnommen werden können.

Die Bauelementgurte weisen herkömmlicherweise feste Gurtschrittweiten auf. Das heißt, in vorbestimmten Abständen von beispielsweise 1 mm, 2 mm, 4 mm, 8 mm usw. ist jeweils ein Bauelement an dem Bauelementgurt angebracht, beispielsweise in eine Tasche des Bauelementgurts eingelegt und mit dem Abdeckband gegen Herausfallen gesichert.

Um eine schnelle Zuführung zu gewährleisten, wurden von herkömmlichen Zuführmodulen die Bauelementgurte unter Abziehen der Abdeckfolie mit hoher Geschwindigkeit aufeinanderfolgend um jeweils eine der fixen Gurtschrittweiten weiter transportiert, um das nächstliegende Bauelement an der Abholposition bereitzustellen.
Hierzu wurden beispielsweise mechanische sequentielle Antriebe verwendet, welche das Stiftrad jeweils um eine Gurtschrittweite weiter transportiert haben, wie beispielsweise in EP 967851 beschrieben.

Zuführmodule für feste, mechanisch vorbestimmte Gurtschrittweiten weisen jedoch den Nachteil auf, dass einerseits nur Gurte einer einzigen Schrittweite verwendet werden können und andererseits eine Korrektur der Abholposition nicht möglich ist, da der Gurt immer um eine vorbestimmte Länge weiter transportiert wird. Besonders bei sehr kleinen Bauelementen besteht jedoch der Bedarf, die Abholposition verändern zu können, um Lageabweichungen des Bauelements in der Gurttasche ausgleichen zu können. Ferner ist es für eine größere Vielfalt von Einsatzmöglichkeiten der Zuführmodule erforderlich, Gurte mit unterschiedlichen Gurtschrittweiten mit einem einzigen Gurtzuführmodul verarbeiten zu können.

Es besteht daher die Aufgabe, ein Bauelementgurt-Transportrad, ein Bauelementgurt-Bauelementegurt-Transportsystem sowie ein Verfahren zum Betreiben eines Bauelementegurt-Transportsystems anzugeben, bei welchem eine Korrektur der Abholposition sowie das Verwenden von Bauelementgurten unterschiedlicher Gurtschrittweite möglich ist.

Diese Aufgabe wird erfindungsgemäß gelöst durch ein Bauelementegurt-Transportrad mit den Merkmalen nach Anspruch 1, ein Bauelementegurt-Transportsystem mit den Merkmalen nach Anspruch 11 sowie ein Verfahren zum Betreiben eines Bauelementegurt-Transportsystems mit den Merkmalen nach Anspruch 14.

Bevorzugte Ausgestaltungen der Erfindung sind in den abhängigen Ansprüchen beansprucht.

Das erfindungsgemäße Bauelementegurt-Transportrad weist im Vergleich zum Stand der Technik viele Vorteile auf. Beispielsweise ist einstückig an dem Transportrad ein Enkoderrad angebracht, welches zur Bestimmung der Position des Transportrads dient. Das Enkoderrad ist beispielsweise durch Permanentmagnete derart ausgestaltet, dass eine eindeutige Zuordnung zwischen der Position des Enkoderrads respektive des Transportrads sowie einem das Enkoderrad erfassenden Sensors gegeben ist. Daher ist auch nach einem Stillstand des Bauelementegurt-Transportrads, welches beispielsweise in einem Zuführmodul für Bauelemente verwendet werden kann, jederzeit die tatsächliche Position des Bauelementgurt-Transportrads ermittelbar. Diese Positionsinformation kann beispielsweise verwendet werden, um die Abholposition eines zu bestückenden Bauelements exakt zu bestimmen.

Beispielsweise ist das Enkoderrad geeignet, zusammen mit dem Sensor einen inkrementellen Wegaufnehmer zu bilden. Dieser kann Permanentmagnete aufweisen, deren Pole sich in radialer Richtung des Bauelementgurt-Transportrads erstrecken, und umfänglich in abwechselnder Polarität an dem Enkoderrad ausgebildet sind. Hierdurch ist es möglich, mittels des Sensors sowohl Sinus- als auch Cosinussignale aus der Position des Enkoderrads relativ zu dem Sensor zu erfassen und daraus die Absolutposition des Transportrads relativ zu dem Sensor zu bestimmen.

Es ist möglich, das Enkoderrad als dünne magnetisierbare Schicht auszubilden oder ein magnetisierbares Material zu verwenden, welches beispielsweise ein Spritzgussmaterial sein kann, aus dem dann die Pole des Enkoderrads zahnartig ausgebildet sind. Es ist jedoch auch möglich, andere als magnetische Kodierungen an dem Enkoderrad vorzusehen, beispielsweise konduktive, optische etc..

Das Transportrad kann eine Markierung aufweisen, mittels welcher seine Null-Position bestimmt werden kann. Diese Markierung kann beispielsweise als optische Markierung, konduktive Markierung und/oder magnetische Markierung ausgebildet sein und an einer beliebigen Stelle des Transportrads angeordnet sein. Beim Durchlaufen der Markierung durch einen Sensor, welcher auch der Sensor sein kann, welcher das Enkoderrad erfasst, ist ein Signal erzeugbar, welches anzeigt, dass das Transportrad sich an seiner Null-Position oder an seiner Ausgangsposition befindet.

Durch die erfindungsgemäße mechanische feste Kopplung zwischen Enkoderrad und Transportrad wird ein beliebiges Positionieren von Bauelement-Gurten ohne begrenzende feste Gurtschrittweiten möglich. Da direkt am Abtrieb des Bauelementgurt-Antriebs die Position des Bauelementegurts erfasst wird, sind hohe Genauigkeiten möglich. Es können beliebige Gurtschrittweiten eingestellt werden. Etwaige Ungenauigkeiten aufgrund von Getriebefehlern wie Spiel oder Nichtlinearität, welche die Positionierungsgenauigkeit verschlechtern würden, sind ausgeschlossen. Um noch höhere Positioniergenauigkeit zu erreichen, können die Transportstifte mit einer Kunststoffbeschichtung versehen sein. Diese führt zu geringeren Verformungen der Transportöffnungen des Bauelementgurts und dadurch zu einer verbesserten Genauigkeit.

Bei dem erfindungsgemäßen Bauelementegurt-Transportsystem ist neben einem erfindungsgemäßen Bauelementegurt-Transportrad auch ein Führungselement, von welchem der Bauelementegurt relativ zu dem Transportrad geführt ist, ein Sensor zum Erfassen der Relativposition des Enkoderrads, der relativ zu dem Sensor, sowie ein Antrieb zum Bewegen des Bauelementegurt-Transportrads um seine Drehachse vorgesehen. Dabei ist die Winkelauflösung des Sensors in Zusammenwirken mit dem Enkoderrad feiner gewählt, als ein eventuell durch den Antrieb und/oder ein am Antrieb vorhandenes Getriebe verursachte Winkelspiel des Transportrads. Das Getriebe ist z. B. ein Schneckengetriebe, wobei das Schneckenrad an dem Transportrad angebracht ist. Unter einer feineren Auflösungen wird im erfindungsgemäßen Sinn eine höhere Auflösung verstanden, so dass die Auflösung des Systems Enkoderrad/Sensor größer ist als ein möglicher Winkelfehler des Antriebs, um auch innerhalb dieses Winkelfehlers die Absolutposition eindeutig bestimmbar zu machen.

Da die Winkelauflösung des Sensors in Zusammenwirken mit dem Enkoderrad feiner ist als eventuell auftretende Winkelspiele des Antriebs ist es möglich, auch nach einem Abschalten des Bauelementegurt-Transportsystems die Absolutposition des Transportrads jederzeit festzustellen, da aus z. B. Sinus-und Cosinussignalen des Sensors die Absolutposition des Transportrads zwischen zwei Enkoderelementen ermittelt werden kann.

Insbesondere kann diese Eigenschaft des erfindungsgemäßen Bauelementegurt-Transportrads in Verbindung mit einem selbsthemmenden Getriebe genutzt werden. Beispielsweise kann als selbsthemmendes Getriebe ein Schneckengetriebe verwendet werden. Dieses ist, sofern es nicht mit Antriebsenergie versorgt wird, selbsthemmend. Daraus ergibt sich, dass während dem Abschalten des Bauelementegurt-Transportsystems sich die Position des Transportrads nur innerhalb des durch das Getriebespiel vorgegebenen Bewegungsbereichs verändern kann. Wird nun die Winkelauflösung des Sensors so gewählt, dass eine Vielzahl von Winkel-Inkrementen innerhalb einer dem Getriebespiel entsprechenden Winkeldifferenz aufgelöst werden können, ist es auch nach dem Abschalten möglich, die Position des Transportrads eindeutig zu bestimmen. Der Abstand zwischen zwei Enkoder-Elementen, beispielsweise den magnetischen Polen, wird auch als eine Enkoder-Periode bezeichnet. Diese Enkoder-Periode entspricht erfindungsgemäß dem Getriebespiel oder ist geringer als diese. Da als Ausgangssignal des Sensors Sinus-und Cosinus-Signale ausgegeben werden können, kann die Position des Enkoders relativ zu dem Sensor beispielsweise über die Akustangens-Funktion interpoliert werden. Somit kann eine sehr hohe Auflösung innerhalb einer Enkoder-Periode realisiert werden. Beispielsweise können innerhalb eines Getriebespiels von 0,6 mm, als eine Enkoder-Periode, 256 Winkel-Inkremente interpoliert werden. Damit beträgt die Auflösung 0,6 mm : 256. Hierdurch ist auch nach dem Abschalten eine eindeutige Positionierung des Transportrads möglich, sofern während der Abschaltung die Positions-Differenz, welche das Transportrad erfahren hat, kleiner ± einer halben Enkoder-Periode, z. B. kleiner ± 0,3 mm am Enkoderrad in obigem Beispiel, beträgt.

Zusätzlich kann eine Steuervorrichtung vorgesehen sein, mit welcher zusammen mit dem Antrieb und dem Sensor ein geschlossener Regelkreis gebildet ist. Hierdurch ist eine jederzeit exakte Einhaltung von vorgegebenen Gurtschrittweiten bzw. Positionen für Abholpositionen von Bauelementgurten gewährleistet.

Um eine noch bessere Zuordnung von Positionen des Transportrads auch nach einem Abschalten des Bauelementegurt-Transportsystems zu ermöglichen, kann die Steuervorrichtung einen Datenspeicher aufweisen, in welchem Daten über die geometrische Zuordnung der Transportstifte des Transportrads zu dem Enkoderrad abgelegt sind. Hierbei wird für jedes Enkoderelement, beispielsweise einen magnetischen Pol, zu jedem oder zumindest einigen Transportstiften die genaue geometrische Zuordnung in Form beispielsweise von kartesischen oder Polarkoordinaten festgelegt. Diese Werte können verwendet werden, um eventuell bei der Herstellung des Bauelementgurt-Transportrads und/oder des Bauelementgurt-Transportsystems auftretende Abweichungen für den Betrieb des Bauelementegurt-Transportsystems auf Null auszugleichen, so dass eine extrem hohe Genauigkeit sowohl beim Einhalten der gewünschten Gurtschrittweite als auch der gewünschten Abholposition der Bauelemente erreicht wird.

Um die Absolutposition des Transportrads bei einem Bauelementgurt-Transportsystem zu bestimmen, wird zum Einen der Bruchteil eines Winkelabstands zweier benachbarter Enkoderelemente aus den Positionen von Enkoderelementen zu dem zu erfassenden Sensor ermittelt. Beispielsweise kann der Sensor Sinus- und Cosinussignale liefern, aus welchem auch innerhalb des Abstands zweier benachbarter Enkoderelemente, wie beispielsweise magnetischer Pole, die absolute Position, beispielsweise durch Akustangensbildung, ermittelt werden kann. Ferner ist erforderlich, einen Zählwert zu erfassen, der eine ganzzahlige Anzahl von Winkelabständen jeweils zweier benachbarter Enkoderelemente angibt. Durch Verknüpfen dieser beiden Informationen ist jederzeit eine Bestimmung der Absolutposition des Transportrads möglich. Auch nach einem Abschalten kann die Absolutposition exakt errechnet werden, wenn zuvor der ganzzahlige Wert der Anzahl von Winkelabständen abgespeichert wird. Beispielsweise kann mit der in dem Bauelementgurt-Transportsystem vorhandenen Restenergie dieser ganzzahlige Wert in einen nichtflüchtigen Speicher, wie beispielsweise einem EEPROM, eingeschrieben werden.

Ferner können Unregelmäßigkeiten in den geometrischen Zuordnungen der jeweiligen Transportstifte des Transportrads zu den jeweiligen benachbarten Enkoderelementen erfasst werden, um diese Unregelmäßigkeiten beim Betrieb auf Null korrigieren zu können. Die ermittelten Unregelmäßigkeiten können beispielsweise in einem nichtflüchtigen Speicher abgespeichert werden. Es ist ausreichend, die Unregelmäßigkeiten ein einziges Mal, vor der Inbetriebnahme eines Bauelementgurt-Transportsystems zu ermitteln und diese in einer Steuervorrichtung desselben oder in einem mit diesem verbundenen Steuerrechner fest abzuspeichern.

Die Erfindung wird unter Bezugnahme auf die Zeichnung näher erläutert. In der Zeichnung zeigen:
Figur 1 eine Draufsicht auf eine bevorzugte Ausführungsform des erfindungsgemäßen Bauelementgurt-Transportrads,
Figur 1a einen Schnitt durch das in Figur 1 gezeigte Transportrad 1 entlang der Schnittlinie S, und
Figur 2 ein schematisches Flussbild des erfindungsgemäßen Verfahrens zum Betreiben eines Bauelementgurt-Transportsystems.

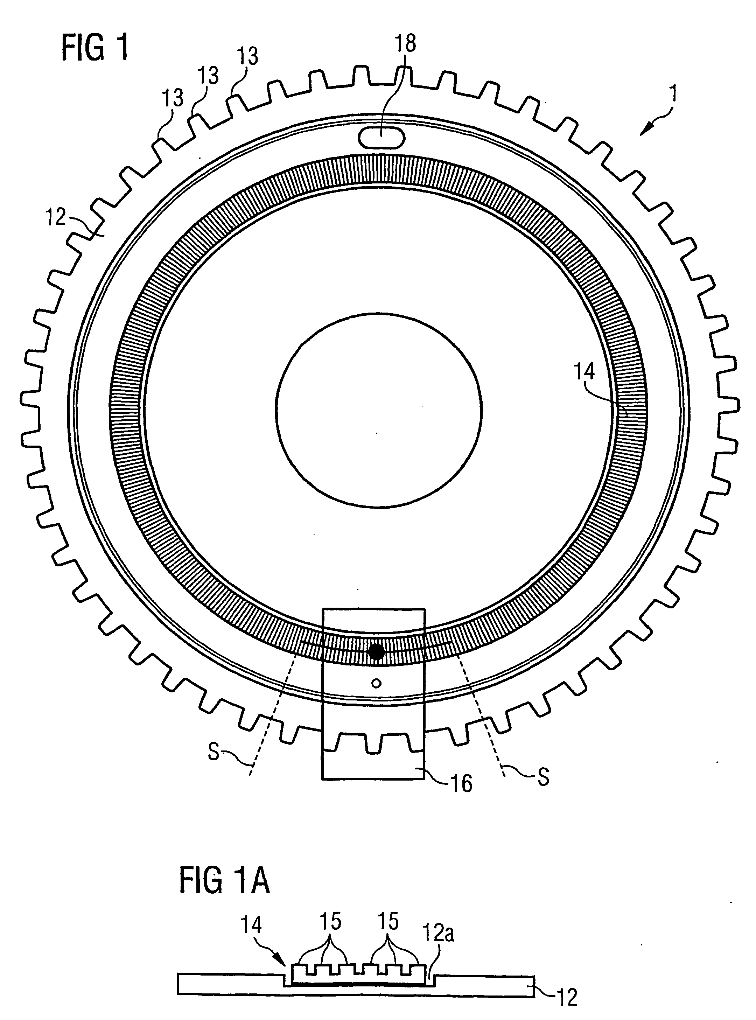

Aus Figur 1 ist eine schematische Draufsicht auf ein erfindungsgemäßes Bauelementegurt-Transportrad ersichtlich. Das Transportrad 1 weist einen im Wesentlichen scheibenförmigen Körper 12 auf, der mit einer Mehrzahl von Transportstiften 13 versehen ist, welche sich jeweils radial erstreckend angeordnet sind. Die Transportstifte 13 sind dazu geeignet, beim Transport von Bauelementgurten in deren Transportöffnungen einzugreifen, um eine Translation der Bauelementgurte zu ermöglichen, welche durch eine Rotation des Transportrads hervorgerufen wird.

An dem scheibenförmigen Körper 12 ist, beispielsweise in einer ringförmigen Vertiefung, ein Enkoderrad 14 angebracht. Das Enkoderrad 14 ist fest mit dem Körper 12 gekoppelt, so dass eine eindeutige Zuordnung der Transportstifte 13 zu den Enkoderelementen des Enkoderrads 14 möglich ist. Wird das erfindungsgemäße Bauelementgurt-Transportrad 1 an einem Sensor 16 vorbeigeführt, welcher die Enkoderelemente des Enkoderrads 14 erfassen kann, so ist in Zusammenwirken mit dem Sensor 16 die Position des Enkoderrads 14 und somit die Position des Transportrads 1 zu einem ortsfesten Referenzpunkt, wie beispielsweise der Position des Sensors 16, eindeutig ermittelbar.

Eine Markierung 18 kann beispielsweise in dem Körper 12 ausgebildet sein. Als Figur 1 ist eine als Öffnung ausgebildete Markierung 18 ersichtlich. Wird diese an einer weiteren Erfassungseinheit des Sensors 16 vorbeigeführt, kann ein Signal ausgegeben werden, welches anzeigt, dass eine Null-Lage oder Null-Position des Transportrads 1 eingenommen ist. Von dieser ausgehend kann durch Zählen der an dem Sensor 16 vorbeibewegten Enkoderelemente des Enkoderrads 14 festgestellt werden, um welchen Winkelbetrag das Transportrad 18 bewegt wurde.

Auch die Transportrichtung kann durch Erfassen der Enkoderelemente des Enkoderrads 14 ausgelesen werden. Beispielsweise kann bei Verwenden eines magnetisch arbeitenden Enkoderrads 14 durch Ausgestaltung der Pole, beispielsweise der Form der Polflanken, die Drehrichtung des Transportrads 1 aus der unterschiedlichen Flankenform des Signals des Sensors 16 ermittelt werden.

Figur 1a zeigt einen Schnitt durch die schematische Ansicht des Transportrads 1 entlang der Schnittlinie S. Wie aus Figur 1a ersichtlich, ist in einer Vertiefung 12a des scheibenförmigen Körpers 12 das Enkoderrad 14 angeordnet. Das Enkoderrad 14 weist eine Vielzahl von Enkoderelementen 15 auf, welche aus Figur 1a als im Wesentlichen zahlenförmige Pole eines magnetisierbaren Enkoderrads 14 aus einem Spritzgussmaterial gezeigt sind. Es ist jedoch auch möglich, das Enkoderrad 14 als eine dünne magnetisierbare Schicht auszubilden, in welcher die Enkoderelemente in Form von magnetisierten Bereichen ausgebildet sind.

Es ist auch möglich, optische und/oder konduktive Enkoderelemente für das Enkoderrad 14 zu verwenden.

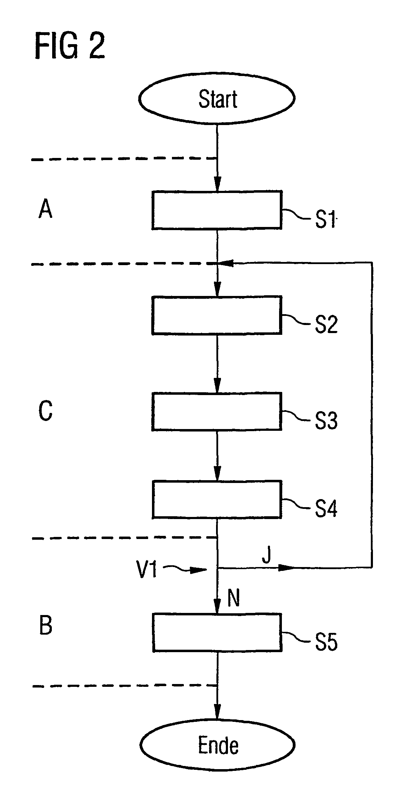

Aus Figur 2 ist ein schematisches Flussbild des erfindungsgemäßen Verfahrens zum Betreiben eines Bauelementegurt-Transportsystems ersichtlich. Wie in der Figur 2 gezeigt, lässt sich das erfindungsgemäße Verfahren grundsätzlich in drei Abschnitte A, B und C unterteilen. Hierbei bilden A und B Abschnitte, welche vor bzw. nach dem Betrieb des Bauelementgurt-Transportsystems optional durchgeführt werden können. C bezeichnet den Abschnitt des tatsächlichen Erfassens der Absolut-Position des Transportrads 1 gemäß der Erfindung mit den Schritten S2 bis S4.

Somit wird das erfindungsgemäße Verfahren mit einem Startschritt in Gang gesetzt. Auf den Startschritt erfolgt in einem Schritt S1 die Erfassung der Null-Position des Transportrads 1. Hierzu wird das Transportrads 1 mittels eines Antriebs (nicht gezeigt) so lange gedreht, bis die Markierung 18 von dem Sensor 16 erfasst werden kann. Ausgehend von dieser Position kann durch Zählen der an dem Sensor 16 vorbeigeführten Enkoderelemente 15 des Enkoderrads 14 der Winkelbetrag der Drehung des Transportrads 1 relativ zu dem Sensor 16 erfasst werden. Das Erfassen der Null-Position im Schritt 1 ist jedoch nicht zwingend erforderlich. Im Schritt 2 wird das Signal des Sensors 16 erfasst. Das erfasste Signal wird im Schritt S3 ausgewertet. Dies kann beispielsweise dadurch erfolgen, dass die Anzahl der an dem Sensor 16 vorbeibewegten Enkoderelemente 15 gezählt bzw. in einem Zählwerk abgelegt und/oder ein Bereich zwischen zwei aufeinander folgenden Enkoderelementen 15 des Enkoderrads 14 durch Auswerten des Sensorsignals, welches beispielsweise als Sinus- und Cosinussignal vorliegt mithilfe einer trigonometrischen Funktion wie beispielsweise der Akustangensfunktion, erfolgt.

In einem Schritt S4 wird der ermittelte Winkelbetrag und die ermittelte Drehrichtung beispielsweise an einer Steuervorrichtung für ein Bauelementegurt-Transportsystem ausgegeben. Soll der Betrieb fortgesetzt werden, wird dies durch ein Ja (J) in einem Schritt V1 entschieden und es erfolgt ein Rücksprung vor den Schritt S2, wo sich das erfindungsgemäße Verfahren entsprechend dem Abschnitt C, wie aus Figur 2 ersichtlich, wiederholt. Bei einem Nein (N) im Entscheidungsschritt V1 kann entweder in einem Schritt S5 die Abspeicherung der Anzahl von an dem Sensor 16 vorbeibewegten Enkoderelementen 15 erfolgen oder es folgt direkt das Ende des erfindungsgemäßen Verfahrens.

## Patentansprüche

1. Bauelementgurt-Transportrad (1) mit einem scheibenförmigen Körper (12), von welchem sich eine Mehrzahl von Transportstiften (13) jeweils radial erstreckt, welche beim Transport von Bauelementgurten in deren Transportöffnungen eingreifen können, **dadurch gekennzeichnet, dass**
• an dem Körper (12) ein Enkoderrad (14) angebracht ist, von welchem in Zusammenwirken mit einem die Position des Enkoderrads (14) erfassenden Sensor (16) die Position des Transportrads (1) eindeutig ermittelbar ist.

2. Bauelementgurt-Transportrad nach Anspruch 1, wobei das Enkoderrad (14) mit dem Sensor (16) zusammen einen inkrementellen Winkelaufnehmer bildet.

3. Bauelementgurt-Transportrad nach Anspruch 1 oder 2, wobei das Enkoderrad (14) Permanentmagnete aufweist, deren Pole (15) sich in radialer Richtung des Bauelementgurt-Transportrads (1) erstrecken und umfänglich in abwechselnder Polarität an dem Enkoderrad (14) ausgebildet sind.

4. Bauelementgurt-Transportrad nach Anspruch 3, wobei das Enkoderrad (14) eine dünne magnetisierbare Schicht aufweist, in welcher die Pole ausgebildet sind.

5. Bauelementgurt-Transportrad nach Anspruch 3, wobei das Enkoderrad (14) ein magnetisierbares Material, insbesondere ein Spritzgussmaterial, aufweist, aus welchem die Pole (15) des Enkoderrads (14) zahnartig ausgebildet sind.

6. Bauelementgurt-Transportrad nach einem der Ansprüche 1 bis 5, wobei das Transportrad (1) mit einer Markierung (18) versehen ist, welche zum Bestimmen einer Nullposition verwendbar ist.

7. Bauelementgurt-Transportrad nach Anspruch 6, wobei die Markierung (18) eine in dem Transportrad (1) ausgebildete Öffnung ist, welche in der Nähe des Enkoderrads (14) angeordnet ist.

8. Bauelementgurt-Transportrad nach einem der Ansprüche 1 bis 7, wobei zusätzlich ein Koppelelement zum Antreiben des Transportrads (1) vorgesehen ist.

9. Bauelementgurt-Transportrad nach Anspruch 8, wobei das Koppelelement ein Schneckenrad ist.

10. Bauelementgurt-Transportrad nach einem der Ansprüche 1 bis 9, wobei zumindest die Transportstifte (13) eine Kunststoffbeschichtung aufweisen.

11. Bauelementgurt-Transportsystem mit einem Bauelementegurt-Transportrad (1) nach einem der Ansprüche 1 bis 10, einem Führungselement, von welchem der Bauelementgurt relativ zu dem Transportrad geführt ist, einem Sensor (16) zum Erfassen der Relativposition des Enkoderrads (16) relativ zu dem Sensor (16), einem Antrieb zum Bewegen des Bauelementgurt-Transportrads (1) um seine Drehachse, einem mit dem Antrieb verbundenen Getriebe zum Übertragen der Antriebskraft an das Bauelementgurt-Transportrad (1), wobei die Winkelauflösung des Sensors (16) in Zusammenwirken mit dem Enkoderrad (14) feiner ist als das durch den Antrieb und/oder das Getriebe verursachte Winkelspiel des Transportrads (1).

12. Bauelementgurt-Transportsystem nach Anspruch 11, zusätzlich mit einer Steuervorrichtung, von welcher zusammen mit dem Antrieb und dem Sensor (16) ein geschlossener Regelkreis gebildet ist.

13. Bauelementgurt-Transportsystem nach Anspruch 12, wobei die Steuervorrichtung einen Datenspeicher aufweist, in welchem Daten über die geometrische Zuordnung der Transportstifte (13) zu dem Enkoderrad (14) abgelegt sind.

14. Verfahren zum Betreiben eines Bauelementgurt-Transportsystems nach einem der Ansprüche 11 bis 13, bei welchem die Winkelposition der Transportstifte
• durch Bestimmen eines Bruchteils des Winkelabstands zweier benachbarter Enkoderelemente (15) aus Relativpositionen von Enkoderelementen zu dem Sensor (16), und
• durch Erfassen eines Zählwerts, welcher eine ganzzahlige Anzahl von Winkelabständen zweier benachbarter Enkoderelemente ist,
ermittelt wird .

15. Verfahren nach Anspruch 14, wobei vorab die geometrischen Zuordnungen der Transportstifte (13) zu jeweiligen benachbarten Enkoderelementen (15) erfasst werden, um Unregelmäßigkeiten zu ermitteln.

16. Verfahren nach Anspruch 15, wobei die ermittelten Unregelmäßigkeiten abgespeichert werden.

17. Verfahren nach Anspruch 16, wobei die ermittelten Unregelmäßigkeiten bei dem Ermitteln der Winkelposition der Transportstifte (13) berücksichtigt werden.

18. Verfahren nach einem der Ansprüche 14 bis 17, wobei die letzte ermittelte ganzzahlige Anzahl von Winkelabständen zweier benachbarter Enkoderelemente (15) vor Beenden des Betriebs des Bauelementgurt-Transportsystems abgespeichert wird.

## Claims

1. Component tape transport wheel (1) having a disc-like body (12), from which a multiplicity of transport pins (13) in each case extend radially, which can engage in the transport openings of component tapes as the latter are transported,
**characterized in that**
• an encoder wheel (14) is fitted to the body (12), from which, in interaction with a sensor (16) that registers the position of the encoder wheel (14), the position of the transport wheel (1) can be determined unambiguously.

2. Component tape transport wheel according to Claim 1, the encoder wheel (14), together with the sensor (16), forming an incremental angle sensor.

3. Component tape transport wheel according to Claim 1 or 2, the encoder wheel (14) having permanent magnets whose poles (15) extend in the radial direction of the component tape transport wheel (1) and circumferentially are formed with alternating polarity on the encoder wheel (14).

4. Component tape transport wheel according to Claim 3, the encoder wheel (14) having a thin magnetizable layer in which the poles are formed.

5. Component tape transport wheel according to Claim 3, the encoder wheel (14) having a magnetizable material, in particular an injection moulding material, from which the poles (15) of the encoder wheel (14) are formed in the manner of teeth.

6. Component tape transport wheel according to one of Claims 1 to 5, the transport wheel (1) being provided with a marking (18) which can be used to determine a zero position.

7. Component tape transport wheel according to Claim 6, the marking (18) being an opening which is formed in the transport wheel (1) and is arranged in the vicinity of the encoder wheel (14).

8. Component tape transport wheel according to one of Claims 1 to 7, a coupling element for driving the transport wheel (1) additionally being provided.

9. Component tape transport wheel according to Claim 8, the coupling element being a worm gear.

10. Component tape transport wheel according to one of Claims 1 to 9, at least the transport pins (13) having a plastic coating.

11. Component tape transport system having a component tape transport wheel (1) according to one of Claims 1 to 10, a guide element, by which the component tape is guided relative to the transport wheel, a sensor (16) for registering the relative position of the encoder wheel (16) relative to the sensor (16), a drive for moving the component tape transport wheel (1) about its axis of rotation, a gear mechanism connected to the drive for transmitting the drive force to the component tape transport wheel (1), the angular resolution of the sensor (16) interacting with the encoder wheel (14) being finer than the angular play of the transport wheel (1) caused by the drive and/or the gear mechanism.

12. Component tape transport system according to Claim 11, additionally having a control device from which, together with the drive and the sensor (16), a closed control loop is formed.

13. Component tape transport system according to Claim 12, the control device having a data memory in which data about the geometric association between the transport pins (13) and the encoder wheel (14) is stored.

14. Method of operating a component tape transport system according to one of Claims 11 to 13, in which the angular position of the transport pins is determined
• by determining a fraction of the angular distance between two adjacent encoder elements (15) from relative positions of encoder elements in relation to the sensor (16), and
• by registering a numerical value which is an integer number of angular distances between two adjacent encoder elements.

15. Method according to Claim 14, the geometric associations between the transport pins (13) and respective adjacent encoder elements (15) being registered in advance in order to determine irregularities.

16. Method according to Claim 15, the irregularities determined being stored.

17. Method according to Claim 16, the irregularities determined being taken into account when determining the angular position of the transport pins (13).

18. Method according to one of Claims 14 to 17, the last integer number of angular distances between two adjacent encoder elements (15) determined before ending the operation of the component tape transport system being stored.

## Revendications

1. Roue de transport de bande de composants (1) avec un corps en forme de disque (12) à partir duquel plusieurs broches de transport (13) s'étendent chacune radialement et peuvent pénétrer lors du transport de bandes de composants dans leurs ouvertures de transport, **caractérisée en ce qu'**il est agencé sur le corps (12) une roue de codage (14) par laquelle la position de la roue de transport (1) peut être déterminée sans équivoque en collaboration avec un capteur (16) détectant la position de la roue de codage (14).

2. Roue de transport de bande de composants selon la revendication 1, la roue de codage (14) constituant conjointement avec le capteur (16) un enregistreur angulaire incrémentiel.

3. Roue de transport de bande de composants selon la revendication 1 ou 2, la roue de codage (14) comportant des aimants permanents dont les pôles (15) s'étendent dans la direction radiale de la roue de transport de bande de composants (1) et sont conçus avec des polarités alternées de manière circonférentielle sur la roue de codage (14).

4. Roue de transport de bande de composants selon la revendication 3, la roue de codage (14) comportant une mince couche magnétisable dans laquelle les pôles sont conçus.

5. Roue de transport de bande de composants selon la revendication 3, la roue de codage (14) comportant un matériau magnétisable, notamment un matériau à mouler par injection, à partir duquel les pôles (15) de la roue de codage (14) sont conçus à la manière de dents.

6. Roue de transport de bande de composants selon l'une des revendications 1 à 5, la roue de transport (1) étant munie d'un repère (18) qui est utilisable pour déterminer une position neutre.

7. Roue de transport de bande de composants selon la revendication 6, le repère (18) étant une ouverture qui est conçue dans la roue de transport (1) et qui est agencée à proximité de la roue de codage (14).

8. Roue de transport de bande de composants selon l'une des revendications 1 à 7, un élément de couplage étant prévu en plus pour l'entraînement de la roue de transport (1).

9. Roue de transport de bande de composants selon la revendication 8, l'élément de couplage étant une roue tangente.

10. Roue de transport de bande de composants selon l'une des revendications 1 à 9, au moins les broches de transport (13) comportant un revêtement en plastique.

11. Système de transport de bande de composants avec une roue de transport de bande de composants (1) selon l'une des revendications 1 à 10, avec un élément de guidage qui guide la bande de composants relativement à la roue de transport, avec un capteur (16) pour la détection de la position relative de la roue de codage (14) relativement au capteur (16), avec un entraînement pour le déplacement de la roue de transport de bande de composants (1) autour de son axe de rotation, avec une transmission reliée à l'entraînement pour la transmission de la force d'entraînement à la roue de transport de bande de composants (1), la résolution angulaire du capteur (16) en relation avec la roue de codage (14) étant plus fine que le jeu angulaire de la roue de transport (1) qui est dû à l'entraînement et/ou à la transmission.

12. Système de transport de bande de composants selon la revendication 11, en plus avec un dispositif de commande qui forme conjointement avec l'entraînement et avec le capteur (16) un circuit de régulation fermé.

13. Système de transport de bande de composants selon la revendication 12, le dispositif de commande comportant une mémoire de données dans laquelle sont enregistrées des données concernant l'association géométrique des broches de transport (13) à la roue de codage (14).

14. Procédé pour faire fonctionner un système de transport de bande de composants selon l'une des revendications 11 à 13, selon lequel on détermine la position angulaire des broches de transport
- en déterminant une fraction de la distance angulaire entre deux éléments de codage (15) voisins à partir de positions relatives d'éléments de codage par rapport au capteur (16)
- et en détectant une valeur de comptage qui est un nombre entier de distances angulaires entre deux éléments de codage voisins.

15. Procédé selon la revendication 14, selon lequel on détecte préalablement les associations géométriques des broches de transport (13) à des éléments de codage (15) voisins respectifs pour déterminer des irrégularités.

16. Procédé selon la revendication 15, selon lequel on mémorise les irrégularités déterminées.

17. Procédé selon la revendication 16, selon lequel, lors de la détermination de la position angulaire des broches de transport (13), on prend en compte les irrégularités déterminées.

18. Procédé selon l'une des revendications 14 à 17, selon lequel on mémorise le dernier nombre entier déterminé de distances angulaires entre deux éléments de codage (15) voisins avant de mettre fin au fonctionnement du système de transport de bande de composants.
